Europäisches Patentamt

(19) European Patent Office

Office européen des brevets

(11) **EP 0 937 262 B1**

(12) **EUROPEAN PATENT SPECIFICATION**

(45) Date of publication and mention
of the grant of the patent:
**02.04.2003 Bulletin 2003/14**

(51) Int Cl.[7]: **G01R 33/32**, G01R 33/60,
G01R 33/36

(21) Application number: **97909503.1**

(22) Date of filing: **24.10.1997**

(86) International application number:
**PCT/GB97/02936**

(87) International publication number:
**WO 98/019175 (07.05.1998 Gazette 1998/18)**

(54) **METHOD FOR REDUCING "DEAD TIME" IN A MAGNETIC RESONANCE APPARATUS**

VERFAHREN ZUR REDUKTION DER "TOTZEIT" IN EINEM GERÄT DER MAGNETISCHEN
RESONANZ

PROCEDE POUR REDUIRE LE "TEMPS MORT" DANS UN APPAREIL A RESONANCE
MAGNETIQUE

(84) Designated Contracting States:
**DE FI FR GB IT**

(30) Priority: **25.10.1996 GB 9622183**

(43) Date of publication of application:
**25.08.1999 Bulletin 1999/34**

(73) Proprietor: **BTG INTERNATIONAL LIMITED**
**London EC4M 7SB (GB)**

(72) Inventors:
• **LURIE, David John**
**Cults, Aberdeen AB15 9JL (GB)**
• **ALECCI, Marcello**
**I-67010 Pizzoci (IT)**
• **BRIVATI, John, Anthony**
**I-67100 L'Aquila (IT)**
• **TESTA, Luca**
**I-67100 L'Aquila (IT)**
• **PLACIDI, Giuseppe**
**I-67018 Sassa (IT)**
• **SOTGIU, Antonello**
**I-67010 Assergi (IT)**

(74) Representative: **Buttrick, Richard**
**BTG International Limited,**
**10 Fleet Place**
**London EC4M 7SB (GB)**

(56) References cited:
**US-A- 3 768 003**          **US-A- 5 068 611**

• **BOURG J ET AL: "RADIOFREQUENCY FT EPR**
**SPECTROSCOPY AND IMAGING" JOURNAL OF**
**MAGNETIC RESONANCE. SERIES B, vol. 102,**
**no. 1, 1 August 1993, pages 112-115,**
**XP000384639 cited in the application**

## Description

The present invention relates to an improved magnetic resonance method in which the dead time of a magnetic resonance apparatus is substantially reduced, or preferably removed. The invention is particularly suitable for use with magnetic resonance imagers and spectrometers.

The invention may be used in applications where the relaxation times $T_1$ and/or $T_2$ are in the sub-microsecond range. The invention is particularly well suited for use with pulsed Electron Paramagnetic Resonance (EPR) at radio frequency in the region of 220 MHz for the detection of free radicals in biological systems. However, it will be appreciated that the applicability is very broad and, for example, the invention may be used for pulsed NMR imaging of solids where the relaxation times may be less than 10 μs.

Continuous wave (CW) radio frequency (rf) (100-300 MHz) EPR has been developed in many laboratories, for example for the detection and imaging of free radicals in small rats. Currently this technique presents some limitations under *in vivo* conditions, such as limited sensitivity (5-50 μM) and slow acquisition rate typically 5 minutes, to obtain a two-dimensional (2-D) image.

The use of pulsed EPR techniques overcomes current limitations. However, in contrast to NMR, the development of pulsed EPR has been very slow. The main reason is that the electron spin relaxation times ($T_1$ and $T_2$) are orders of magnitude shorter (100 ns to 10 μs) than the typical nuclear relaxation times (10 ms to 1 s). These shorter relaxation times place extreme demands on experimental and technical conditions such as pulse duration, pulse power, instrumental dead time, and digital electronics hardware. Only in the last decade or so have pulsed EPR instruments, operating at X-band (9 GHz), been proposed and only very recently become commercially available.

A pulsed EPR spectrometer specifically developed for imaging applications and operating at 300 MHz was proposed by Bourg *et al*., in J. Magnetic Resonance B, 102, 112 (1993). In the design of this instrument the classical NMR-type duplex configuration - a small coil transmitter/receiver with passive receiver protection - was employed. A very small solenoid coil (four-turn coil, 8 mm in diameter) was used. This ensured a very high efficiency factor, β, of the coil defined as: $\beta = (B_1/\sqrt{P})$, where $B_1$ is the amplitude of the rf magnetic field and P is the power incident on the coil. The device allowed operation with a very small sample ($\approx 2$ ml) and at low rf power levels and, consequently, a short instrumental dead time (TD) was obtained.

Unfortunately, the design followed by Bourg *et al*., is not suitable when large samples (10 to 100 ml) are used. In fact, the efficiency factor of the resonator *decreases* with the sample volume, requiring the use of high rf power. Because the dead time *increases* with the rf power, it can become very difficult, if not impossible, to detect the free induction decay (FID) signal of a paramagnetic species with short relaxation times. This represents a strong instrumental limitation for the development of pulsed rf EPR and reduces the potential biological applications of the technique. A similar problem has been experienced in solid nuclear magnetic resonance apparatus.

A number of problems are suffered by Magnetic Resonance Imagers and Spectrometers which degrade images and signals. In order to obtain adequate signals and good signal-to-noise ratio (SNR), it is necessary to have fast rf pulse application, a high rf power input capability and efficient resonators. In addition to this it is highly desirable to have fast data acquisition and electronic processing capability as well as a short instrumental dead time. The dead time of an instrument limits its ability to detect any events until it recovers. Accordingly when an instrument is in its dead time it is unable to detect anything of use.

The primary source of instrumental dead time is the ringing of the cavity or resonator, and the dead time of a magnetic resonance instrument ($T_D$) can be expressed as:

$$T_D = \tau_D \cdot \ln (P^*_{TX}/P_{NOISE})$$

where $P^*_{TX}$ is the transmitted power leaking to the receiver and $P_{NOISE}$ is the detector noise. $\tau_D$ is the resonator ringing time and is itself expressed as:

$$\tau_D = 1/\pi\Delta\nu$$

where $\Delta\nu$ is the bandwidth of the resonator.

There are a number of ways in which dead-time can be reduced. For example, the bandwidth ($\Delta\nu$) of the resonator can be increased by reducing the quality factor (Q). However, this has the effect of reducing sensitivity and, because more transmitter power is required, more power can leak to the receiver. Overcoupling of the resonator tends to reduce the dead-time, but gives rise to harmonics and interference due to reflected waves. Such interference can damage amplifiers and there is a risk that more power will leak into the receiver coil. It is known that the ringing time of a resonator may be reduced by reversing the RF pulse (i.e. phase shifting it by 180E) for a short time period at the end of the main pulse. This 'quenching' pulse results in the microwave magnetic field $B_1$ in the cavity tending not to zero but to a negative value in the rotating frame with the same time constant. During this process $B_1$ crosses the zero value. If the quenching pulse is switched off right at the moment of zero crossing there is no more energy left in the cavity to radiate. This technique therefore results in at least partial cancellation of the ringing of the resonator, but its effects are limited. US 3 768 003 discloses in its background section, an approach to reducing dead time, where a dummy coil is used in bridge configuration with a signal coil. The two-part form of the independent claim reflects the disclosure of this document. US 5 068 611 discloses an arrangement with a pair of coils which attempts to remove external noise fault signals by processing a 90 degree shifted version of the signal derived from one coil together with the signal from the other coil. It does not approach the problem of reducing coil ringing effects or dead time.

Alternatively, electronic equipment may be enhanced to reduce the dead-time, but this merely addresses the symptoms of prolonged dead-time, not the cause. Consequently there will always be a limit imposed on the technique.

The present invention arose in an attempt to solve the problem of dead-time in magnetic resonance apparatus at its source, rather than try to solve the symptoms.

According to the present invention there is provided a method according to claim 1.

Preferably the first RF signal is inverted and then combined with the second RF signal to provide said difference signal. The relative amplitude between the first and second RF signals may be adjusted.

The subtraction of one signal from the other greatly reduces the time necessary for the transmitted rf pulse energy to reach the noise level or a predetermined fixed level. This makes it possible to switch on one channel only or two channels simultaneously and thereby selectively detect the FID signal much earlier than before. The effect is that the dead time is reduced or preferably removed. Consequently the invention may be used with EPR or solid NMR where relaxation times $(T_1, T_2)$ are of the order of 100 nanoseconds (ns) to 10 microseconds ($\mu$s).

The application of said RF excitation pulse may be followed by the application of a phase-reversed RF pulse. This second RF pulse has the beneficial effect of further reducing the dead time.

In one embodiment of the invention, at least one of said first and second RF receiver coils is used to apply said RF excitation pulse.

In an alternative form of the invention, separate coils are used for said RF transmitter coil and said first and second RF receiver coils, all three coils being mutually perpendicular.

The apparatus is preferably tuned to a frequency of the order of a few hundred MHz and is capable of accommodating samples of sizes of typically in the range of 10 ml to several hundred ml. Further details of the transmit and receive coils (TX/RX) are given below as well as experimental results showing the use of the TX/RX with CW and pulsed EPR spectroscopy.

Preferred embodiments of the invention will now be described, by way of example only, with reference to the accompanying drawings in which:

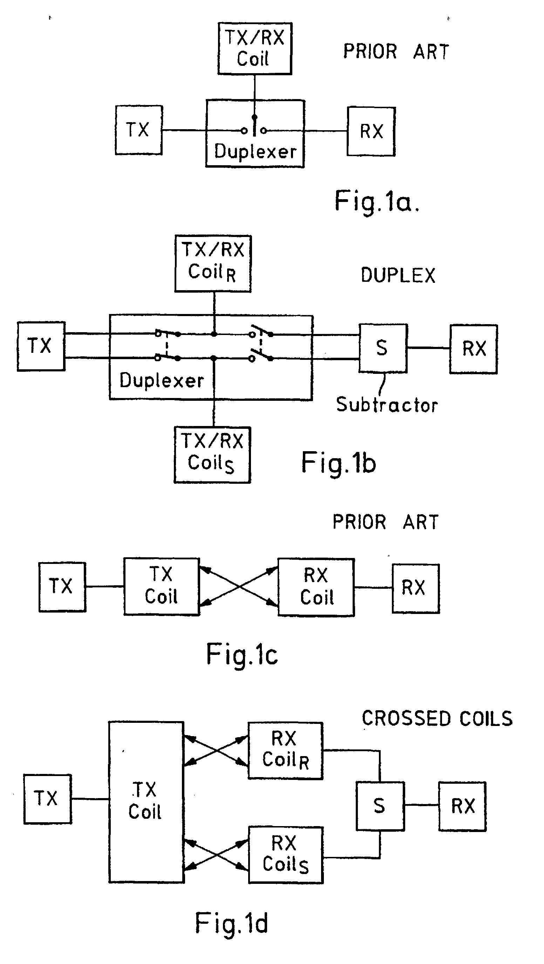

Figure 1 is a diagrammatical view of two embodiments of the invention in (b) a duplex configuration, (d) a cross coupled coil configuration and also showing corresponding prior art versions of each configuration (respectively (a) and (c);

Figure 2 is a circuit diagram of the embodiment of the invention (duplex configuration) corresponding to that shown in Figure 1 (b);

Figure 3 is a schematic diagram of the embodiment of the invention (crossed coupled coil configuration) shown in Figure 1(d);

Figure 4 is a schematic view of a crossed coil arrangement showing diagrammatically a TX loop-gap resonator, saddle shaped RXS and RXR resonators, an rf shield and a mechanical support structure;

Figure 5 show graphs of measured: (a) reflection coefficient ($S_{11}$) of the TX loop gap resonator, (b) isolation (I) of the RXR resonator only, (c) isolation of the RXS resonator only, (d) out-of-phase combination of RXS and RXR resonators; and (e) in-phase combination of RXS and RXR resonators;

Figure 6 is a graph showing measured (a) the TX rf pulse (b) the decay of rf pulse with single channel detection using RXS only (or RXR only) and (c) the decay of rf pulse with double channel out-of-phase compensation according to the invention;

Figure 7 is a graph of measured EPR signals against magnetic field strength showing an EPR spectrum for a free radical test sample, obtained in CW mode at 220 MHz, in which (a) is the RXS channel receiving, and (b) is the RXR channel receiving;

Figure 8 is a graph of EPR pulsed detection of FID of lithium phthalocyanine ($10^4$ pulses, averaged over 30 seconds) with a TX/RX assembly tuned to 220 MHz at 8.1mT; and

Figure 9 is a timing diagram showing an example of a pulse sequence and diagrammatically the beneficial effect of the invention.

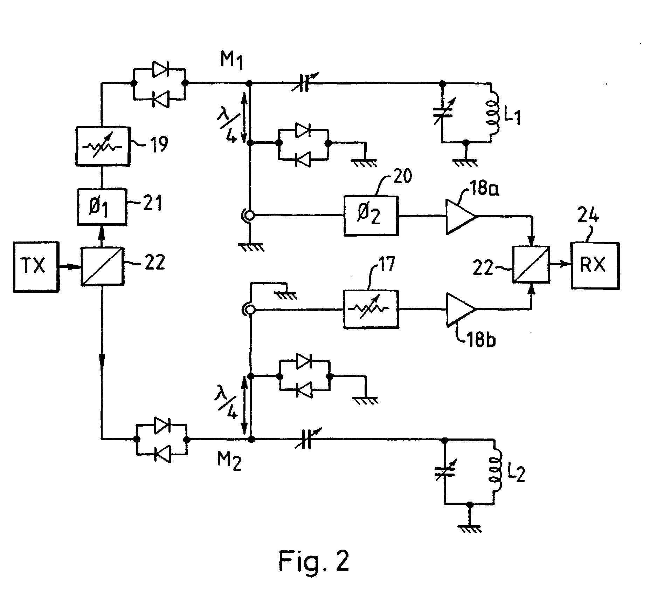

In Figure 2 a duplex configuration of the transmitter/receiver of the invention is illustrated. The two coils $L_1$ and $L_2$ are mutually perpendicular and are used both to transmit and receive RF signals, with a conventional passive transmit/receive switching arrangement - to isolate the transmitter from the receiver at any given time - as shown $\varnothing_1$ phase shifter 21 is used as a 90° shifter to provide that the two coils transmit in phase, and attenuator 19 is used to balance the transmitted signals. In the receiver circuit, $\varnothing_2$ phase shifter 20 is a 180° shifter to invert the signal received from $L_1$, whilst attenuator 17 is used to balance the amplitudes of the received ringing signals. 18a and 18b are low-noise preamplifiers, whilst a power combiner 22 sends the combined signal to receiver 24 from where it can be processed to provide an image. It is, of course, also possible to apply the RF signal through only one coil ($L_1$, or $L_2$), and then switch to receive via both coils.

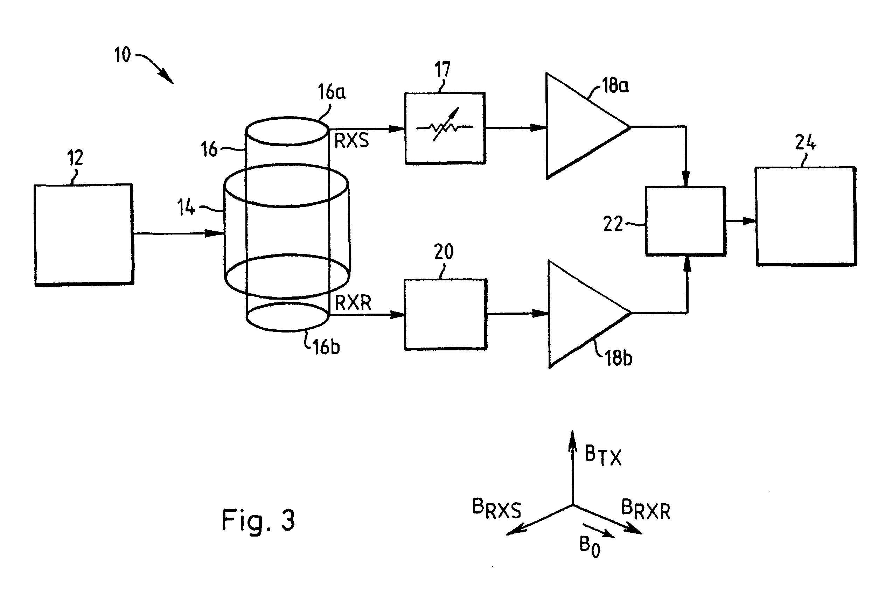

To improve the isolation between the transmitter and the receiver a crossed coupled coil configuration is preferred (see Figure 3), in which a third RF coil is provided as a transmitter, and the two coils $L_1$ and $L_2$ are used as receiver coils only. High isolation is achieved by arranging the receiving coils perpendicular to the RF transmitter resonator.

Referring to Figure 3 a magnetic resonance apparatus 10 of the TX/RX type is shown. A crossed coil configuration with a separate transmitter (TX) resonator and a receiver (RX) resonator has an rf pulse generator 12, a TX resonator coil 14, a double-channel RX resonator coil 16 and a variable rf attenuator 17. Also shown are low-noise preamplifiers 18a and 18b and a 180° phase shifter 20. A power combiner 22 combines signals from the two amplifiers 18 and sends the combined signal to receiver 24 from where it is processed. The two separate coils 14 and 16 (TX and RX) are geometrically perpendicular to one another and are tuned to the same frequency. This provides a high isolation (30 - 40 dB) between TX and RX, with a consequent reduction of $T_D$. A similar design was proposed in the early years of NMR spectroscopy by J.A. Pople, W.G. Schneider and H.J. Bernstein in 'High Resolution NMR', McGraw Hill (1959), and more recently in CW NMR imaging of solids by D.J. Lurie *et al.* in International Patent Application WO-A-97/07412 and in EPR, G.A. Rinard *et al.*, Proceedings 19th Inst. EPR Symposium, Abstract No. 147, Denver, USA, July 21-26 (1996).

The RX coil comprises two identical coils 16a and 16b which are geometrically perpendicular to each other and both their $B_1$ fields are perpendicular to the TX field. In principle, the two receiving coils have identical rf parameters, i.e. resonant frequency ($f_0$), quality factor (Q), bandwidth ($\Delta v$), ringing time ($\tau_D$). One of the two receiving coils 16a is perpendicular to the main field and is used as a receiver (RXS) for the FID signal of the paramagnetic (or nuclear) probes; the other receiving coil 16b (RXR) is parallel to the main field and is used to reduce the ringing time of the instrument.

The ringing voltages generated by the two coils 16a and 16b (RXS and RXR) are assumed to be identical, since they are excited in the same way by the same power pulse from the TX coil 14. This assumption is reasonable since isolation between the two coils 16a and 16b is typically 20 to 40 dB. As shown for example in Figure 3, the output of RXS is amplified and connected to one input of a power combiner, giving rise to the FID; while the output of RXR is shifted in phase by 180°, amplified and finally connected to the other input of the power combiner. At the output of power combiner 22 there is a very marked reduction of the dead time (TD) as a result of the out-of-phase cancellation of the ringing-down voltage of the two RX coils 16a and 16b. However, the FID's generated by RXS and RXR are in quadrature, because the two receiving coils 16a and 16b are geometrically perpendicular, and the combination will not cancel. For ease of operation, in the embodiment illustrated, RXR coil 16b is oriented parallel to the main magnetic field $B_0$ and it will therefore not detect any FID, but the system will work for any orientation of the TX/RX coils with respect to the main field.

As an example, a prototype TX/RX assembly is described with some preliminary experiments obtained with CW and pulsed EPR at 220 MHz with specific reference to Figures 3 to 9.

## Design of the TX section

The TX section, schematically shown in Figure 3, has an rf source 12 (Hewlett Packard model HP8640B, not shown) which generates the 220 MHz signal connected to the TX pulse switch (Mini-Circuit, ZYSWA-2-50DA not shown). The circuit is controlled by the main pulse generator (Tabor (TRADE MARK) electronics, model 8600 not shown). The rf pulse (minimum width 15 ns) is amplified 40 dB by a high power amplifier (Mini-Circuit, ZHL-5W-1, not shown) giving 4 W rms output. This power is connected to an NMR-type crossed diodes (Philips, BAW62 not shown) circuit with ë/4 line tuned to 220 MHz, that provides a threshold barrier to remove the noise of the TX (minimum 60 dB) and the falling edge of the transmitter pulse. Such a circuit is described in detail in P. Mansfield and P.G. Morris, 'NMR Imaging in Biomedicine', Suppl. 2, Advances in Magnetic Resonance, Academic Press 1982, at page 281. The pulsed power is connected, via a phase shifter (not shown) to a loop-gap TX resonator. The function of the phase shifter is to optimise the tuning/matching of the TX resonator to the source.

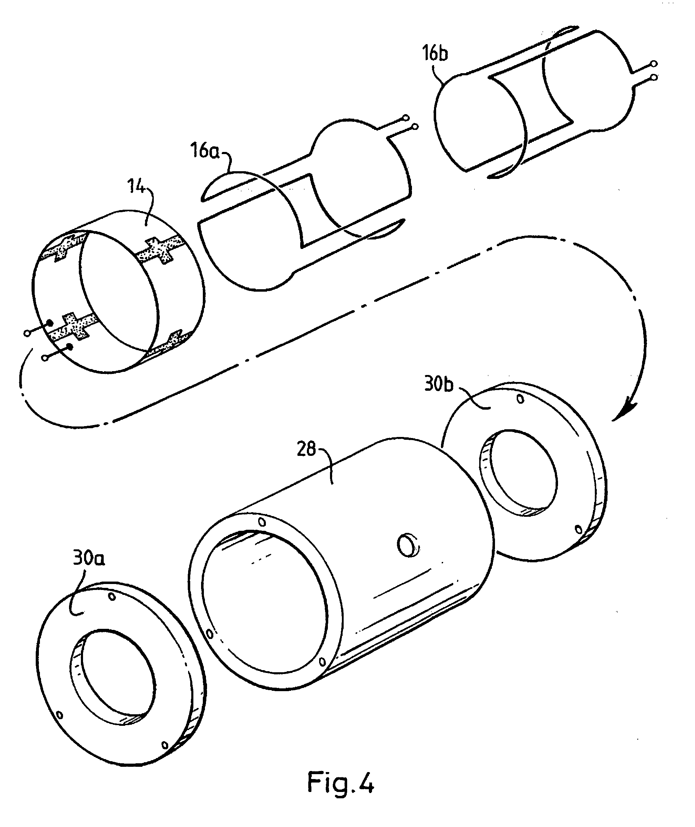

The TX resonator 14, see Figure 4, is a one-loop, four-gap resonator, for example of the type described by W. Froncisz and J.S. Hyde in J. Mag. Res., Vol. 47 (1982) at page 515, with diameter 59 mm and length 20 mm. The resonator is contained in a brass shield 28, Figure 4, with internal diameter 75 mm and length 90 mm. The inductive elements of the particular resonator are obtained from four strips (20 X 44 X 0.076 mm) of adhesive copper (RS components, UK). Four identical high quality factor (Q) chip-capacitors (Murata Inc., USA) of 36 pF are used to tune the resonator to 220 MHz. The use of one capacitive trimmer 5530 pF (Q> 500) allows tuning of the resonator over a range of 14 MHz. The resonator has an unloaded quality factor ($Q_{TX}$) of 170 when empty, whereas $Q_{TX}$ is 100 with 55 ml of physiological saline solution sample. The TX resonator is coupled to the rf source by a standard $\lambda/4$ triaxial balun and a balanced capacitive network (C.N. Chen and D.I. Hoult 'Biomedical Magnetic Resonance Technology', IOP Publishing, UK 1989).

## Design of the RX section

The receiving resonator is composed of two identical pairs of saddle coils 16a and 16b, as shown in Figure 4. The two sections of the resonator (RXS and RXR) are perpendicular and they serve to reduce the dead time of RX, as illustrated below. A TEFLON (Registered Trade Mark) tube (not shown) 36 mm in diameter is used for the construction of the RXS and RXR sections of the resonator. Each saddle is made by adhesive copper strip (RS components, UK) 4 mm wide. The angular aperture of the saddle is 82° and the length is 50 mm. The two parts of each saddle pair are connected in parallel by 35 mm of RG176 cable. At the end of the cable a capacitive high Q trimmer (357 pF) allows fine tuning of the resonator to 220 MHz. As for the TX resonator, a standard $\lambda/4$ triaxial balun and a balanced capacitive network is used to couple each of the two receiving coils. The unloaded quality factor ($Q_{RX}$) of the empty receiving resonators is 105, and after the insertion of 55 ml of physiological solution QRX of 35. The output of RXS is amplified by a low-noise preamplifier (Mini Circuit, MAN-1-HLN) and connected to one input of a power combiner (Mini Circuit, ZFSCJ-2-1). The output of RXR is connected to a 180° phase-shifter before pre-amplification and connection to the other input of the power combiner. A continuously variable rf attenuator is inserted after the RXS coil to reduce the imbalance between the two receiving channels.

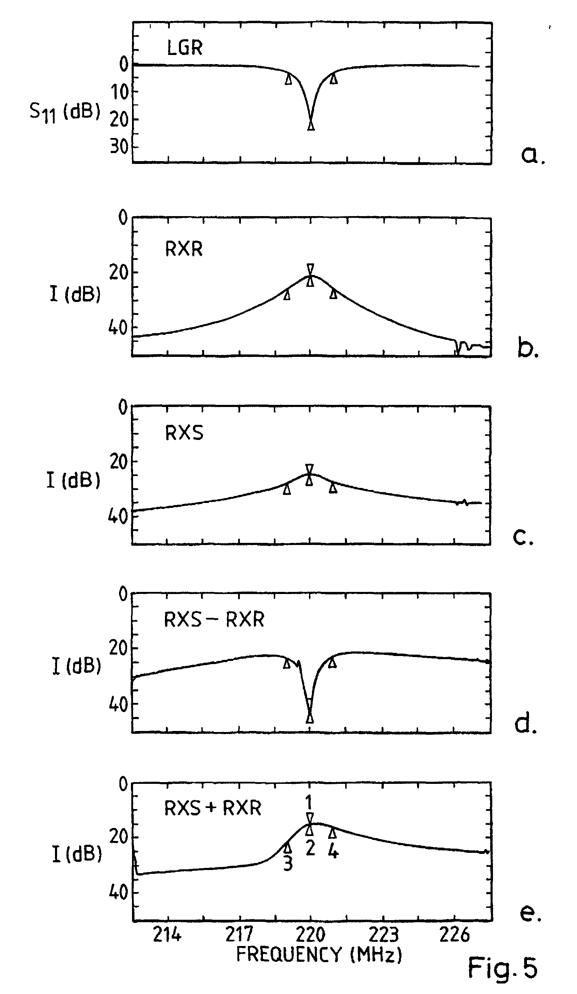

For the prototype assembly, a network analyser (HP8753A) was used to measure the isolation between the TX/RX coils with 55 ml of physiological solution inserted in the resonator. The TX loop-gap resonator (LGR) was used as transmitter (Figure 5a) and isolation was measured with the RXR receiver only (Figure 5b). Alternatively the RXS coil may be used as shown in Figure 5c or an out-of-phase combination of RXS and RXR may be used, as shown in Figure 5d. In these conditions a marked increase of the isolation (40 - 50 dB) at the resonant frequency, within a bandwidth of a few MHz, was observed. For comparison Figure 5e shows the isolation measured with the in-phase combination of RXS and RXR.

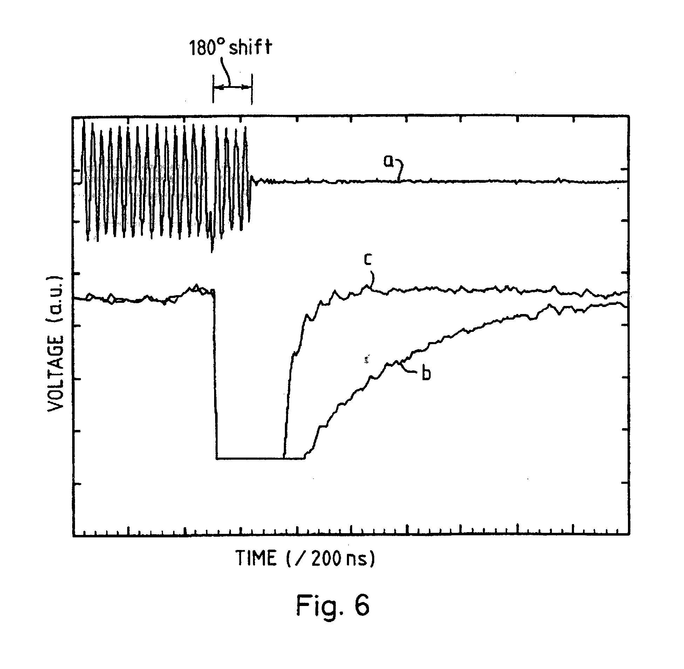

The output of power combiner 22 was connected to a rf switch (Mini-Circuit, ZYSWA-2-50DA), amplified (70 dB) and detected by a balanced mixer (Mini-Circuit, ZAD-1) whose local oscillator input was obtained from the rf source via a power splitter (Mini-Circuit, ZFSC-2-2). The output of the mixer was observed with a digital oscilloscope (Tektronix, TDS 540). Under these conditions, the decay of the rf pulse in the TX/RX assembly was measured. A high power (4 W rms) rf pulse of 400 ns in length was applied to the TX resonator (Figure 6). The pulse shown employed phase reversal (180° shift) in order to further reduce the dead time. The ringing down was observed with single channel detection using RXS only (trace b of Figure 6) and with double-channel out-of-phase combination using RXS and RXR (trace c). As the experimental results show, a significant reduction in the dead time with double-channel detection is obtained.

Continuous Wave (CW) EPR detection at 220 MHz

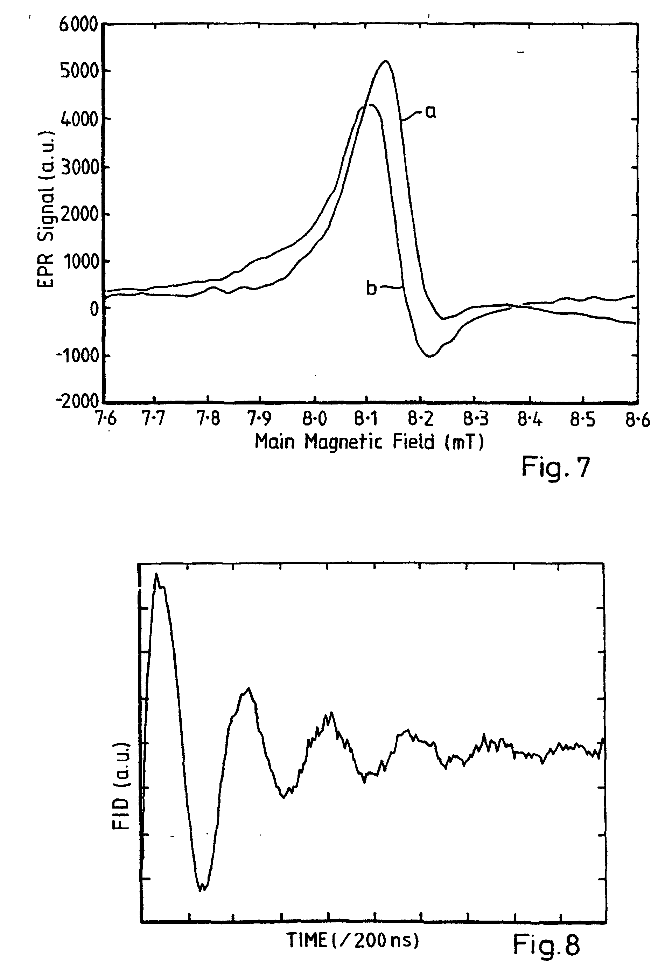

To show the equivalence of the EPR signal detected by the two receiving channels RXS and RXR, experiments were performed with an rf spectrometer operating in CW mode. The TX loop-gap resonator, tuned to 220 MHz, is used as transmitter. Either an RXS or an RXR channel is used as a receiver. Because no Automatic Frequency Control (AFC) was used, measured spectra are a mixture of absorption and dispersion components. A sample of DPPH (a,a'-diphenyl-$\beta$-picryl-hydrazyl) was used and, as shown in Figure 7, the two spectra (a and b) are so close as to be practically equivalent.

Pulsed EPR detection at 220 MHz

Preliminary results of pulsed EPR were obtained using a TX/RX assembly tuned to 220 MHz. A sample of 1.5 g of lithium phthalocyanine (LiPtc) powder, previously de-oxygenated, and contained in a small cylinder and inserted in a sample tube containing 50 ml of physiological saline solution, was used. The measured linewidth of LiPtc is approximately 0.02 mT. Figure 8 shows a FID signal obtained with the main magnetic field selected very close to the resonance value. Although these are preliminary results, and the pulsed EPR spectrometer has not been optimised, a good signal-to-noise ratio was observed when the resonator was loaded with a large volume saline solution.

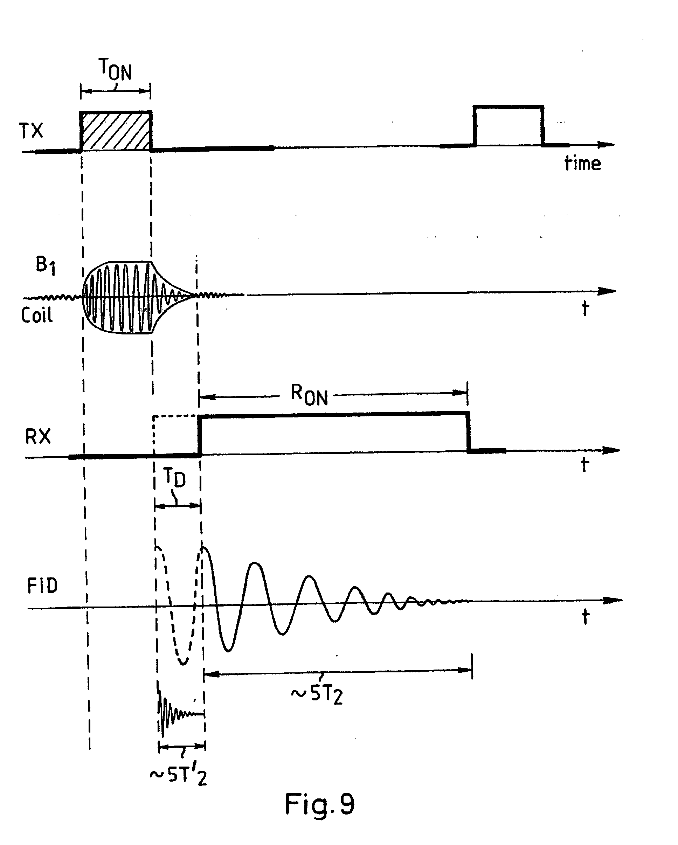

In the timing diagram of Figure 9 the conventional 'ringing down' of the $B_1$ field of the transmitter is illustrated, signifying that only FID signals with relatively long $T_2$ times can be measured. However, when the present invention is employed, FID signals with significantly shorter $T_2$ times (such as the $T_2'$ decay shown in the figure) can be detected. $T_2'$ is of such a small magnitude that, using conventional apparatus, the FID signal will have decayed substantially to zero ($\sim 5\,T_2'$) during the instrumental dead time

In the embodiments illustrated above, the two RF receiver resonators are arranged mutually orthogonally, although this is not essential providing that they are arranged to detect fields in mutually non-parallel directions, in order that discrimination of the FID signal can be achieved by combination of the received signals.

The above embodiment has been described by way of example only and it will be understood that variations may be made to it without departing from the scope of the invention.

**Claims**

1. A method of magnetic resonance investigation of an object comprising the steps of:

   applying a static magnetic field to the object;

applying an RF excitation pulse to the object; detecting the RF response from said object after the RF excitation pulse has ceased, said method being said RF response being detected as a first RF signal (RXS) by means of a first RF receiver coil (16a) and as a second RF signal (RXR) by means of a second RF receiver coil (16b), **characterized in that** said first and second RF receiver coils are substantially identical, have substantially identical ringing characteristics, do each surround said object and are arranged geometrically in mutually non-parallel directions; and

the method being further **characterized by** providing an output signal which is the difference between said first RF signal and said second RF signal, said output signal being substantially free from ringing effects.

2. A method according to Claim 1, wherein the first RF signal is inverted, and then combined with the second RF signal to provide said difference signal.

3. A method according to Claim 1 or Claim 2, wherein the relative amplitude between the first and second RF signals is balanced for optimum cancellation of said ringing.

4. A method according to any preceding claim, wherein application of said RF excitation pulse is followed by application of a phase-reversed RF pulse.

5. A method according to any preceding claim, wherein at least one of said first and second RF receiver coils is used to apply said RF excitation pulse.

6. A method according to any preceding claim, wherein the carrier frequency of the RF excitation pulse is of the order of a few hundred MHz.

7. A method according to Claim 5, wherein the at least one coil is switched between a transmit mode and a receive mode.

8. A method according to any one of Claims 1-4, wherein separate coils are used as an RF transmitter coil and as said first and second RF receiver coils, all three coils being mutually perpendicular.

9. A method according to any one of Claims 1-8 including providing an image by the technique of nuclear magnetic resonance, on the basis of said output signal.

10. A method according to any one of Claims 1-8, including providing an image by the technique of electron paramagnetic resonance, on the basis of said output signal.

**Patentansprüche**

1. Verfahren zur magnetischen Resonanz-Untersuchung eines Objekts, umfassend die Schritte:

Anlegen eines statischen Magnetfeldes an das Objekt;
Anlegen eines RF-Erregerimpulses an das Objekt;
Erfassen der RF-Antwort von dem Objekt nachdem der RF-Erregerimpuls abgeklungen ist, wobei die RF-Antwort als ein erstes RF-Signal (RXS) mittels einer ersten RF-Empfängerspule (16a) und als ein zweites RF-Signal (RXR) mittels einer zweiten RF-Empfängerspule (16b) erfasst wird, wobei das Verfahren

**dadurch gekennzeichnet ist, dass** die erste und die zweite RF-Empfängerspule im Wesentlichen identisch sind, eine im Wesentlichen identische Nachschwing-(Ringing)Charakteristik besitzen, jeweils das Objekt umgeben und geometrisch in relativ zueinander nicht-parallelen Richtungen angeordnet sind; und
wobei das Verfahren weiter **dadurch gekennzeichnet ist, dass** ein Ausgangssignal zur Verfügung gestellt wird, das die Differenz zwischen dem ersten RF-Signal und dem zweiten RF-Signal darstellt, wobei das Ausgangssignal im Wesentlichen frei von Nachschwingeffekten ist.

2. Verfahren nach Anspruch 1,
**dadurch gekennzeichnet, dass** das erste RF-Signal invertiert wird und anschließend mit dem zweiten RF-Signal kombiniert wird, um das Differenzsignal zu bilden.

3. Verfahren nach Anspruch 1 oder 2,
**dadurch gekennzeichnet, dass** die Relativamplitude zwischen dem ersten und zweiten RF-Signal zur optimalen Auslöschung des Nachschwingens abgeglichen wird.

4. Verfahren nach einem der vorhergehenden Ansprüche,
**dadurch gekennzeichnet, dass** dem Anlegen des RF-Erregerimpulses das Anlegen eines RF-Impulses mit umgekehrter Phase folgt.

5. Verfahren nach einem der vorhergehenden Ansprüche,
**dadurch gekennzeichnet, dass** die erste und/oder die zweite RF-Empfängerspule zum Anlegen des RF-Erregerimpulses verwendet wird.

6. Verfahren nach einem der vorhergehenden Ansprüche,
**dadurch gekennzeichnet, dass** die Trägerfrequenz des RF-Erregerimpulses in der Größenordnung einiger hundert MHz liegt.

**7.** Verfahren nach Anspruch 5,
**dadurch gekennzeichnet, dass** die mindestens eine Spule zwischen einem Sendemodus und einem Empfangsmodus geschaltet wird.

**8.** Verfahren nach einem der Ansprüche 1 bis 4,
**dadurch gekennzeichnet, dass** als eine RF-Senderspule und als die erste und die zweite RF-Empfängerspule getrennte Spulen verwendet werden, wobei sämtliche drei Spulen senkrecht zueinander angeordnet sind.

**9.** Verfahren nach einem der Ansprüche 1 bis 8, beinhaltend das zur Verfügung Stellen eines Bildes auf der Grundlage des Ausgangssignals mittels der Technologie der Kernspinresonanz (NMR).

**10.** Verfahren nach einem der Ansprüche 1 bis 8, beinhaltend das zur Verfügung Stellen eines Bildes auf der Grundlage des Ausgangssignals mittels der Technologie der Elektronen-paramagnetischen-Resonanz (EPR).

**Revendications**

**1.** Procédé d'examen par résonance magnétique d'un objet comportant les étapes consistant à :

appliquer un champ magnétique statique à l'objet,
appliquer une impulsion d'excitation à haute fréquence (RF) à l'objet,
détecter la réponse RF provenant dudit objet après que l'impulsion d'excitation RF ait cassé, ladite réponse RF étant détectée sous forme d'un premier signal RF (RXS) par l'intermédiaire d'une première bobine réceptrice RF (16a) et sous forme d'un second signal RF (RXR) par l'intermédiaire d'une seconde bobine réceptrice RF (16b), ledit procédé étant **caractérisé en ce que** lesdites première et seconde bobines réceptrices RF sont sensiblement identiques, ont des caractéristiques d'oscillation sensiblement identiques, entourent chacune ledit objet et sont agencées géométriquement dans des directions mutuellement non-parallèles, et le procédé étant en outre **caractérisé en ce qu'**il fournit un signal de sortie qui est la différence entre ledit premier signal RF et ledit second signal RF, ledit signal de sortie étant sensiblement exempt d'effets d'oscillation.

**2.** Procédé selon la revendication 1, dans lequel le premier signal RF est inversé, et ensuite combiné avec le second signal RF pour délivrer ledit signal de différence.

**3.** Procédé selon la revendication 1 ou la revendication 2, dans lequel l'amplitude relative entre les premier et second signaux RF est équilibrés pour obtenir une annulation optimale de ladite oscillation.

**4.** Procédé selon l'une quelconque des revendications précédentes, dans lequel l'application de ladite impulsion d'excitation RF est suivie de l'application d'une impulsion RF à phase inversée.

**5.** Procédé selon l'une quelconque des revendications précédentes, dans lequel au moins une desdites première et seconde bobines réceptrices RF est utilisée pour appliquer ladite impulsion d'excitation RF.

**6.** Procédé selon l'une quelconque des revendications précédentes, dans lequel la fréquence de porteuse de l'impulsion d'excitation RF est de l'ordre de quelques centaines de mégahertz (MHz).

**7.** Procédé selon la revendication 5, dans lequel la au moins une bobine est commutée entre un mode de transmission et un mode de réception.

**8.** Procédé selon l'une quelconque des revendications 1 à 4, dans lequel des bobines séparées sont utilisées en tant que bobine émettrice RF et en tant que lesdites première et seconde bobines réceptrices RF, les trois bobines étant toutes mutuellement perpendiculaires.

**9.** Procédé selon l'une quelconque des revendications 1 à 8, incluant la fourniture d'une image par la technique de résonance magnétique nucléaire, sur la base dudit signal de sortie.

**10.** Procédé selon l'une quelconque des revendications 1 à 8, incluant la fourniture d'une image par la technique de résonance paramagnétique électronique, sur la base dudit signal de sortie.

PRIOR ART

Fig.1a.

DUPLEX

Subtractor

Fig.1b

PRIOR ART

Fig.1c

CROSSED COILS

Fig.1d

8

Fig. 2

Fig. 3

EP 0 937 262 B1

Fig.4

Fig. 5

180° shift

VOLTAGE (a.u.)

TIME (/ 200 ns)

Fig. 6

Fig. 7

Fig. 8

Fig. 9